# EUROPÄISCHE PATENTANMELDUNG

(11) **EP 1 248 020 A2**
(43) Veröffentlichungstag der Anmeldung: **09.10.2002**
(21) Anmeldenummer: 02100268.8
(22) Anmeldetag: 18.03.2002
(51) Int. Cl.: F16H 61/00

(54) **Elektronisch-hydraulisches Getriebesteuermodul und Herstellungsverfahren**

(30) Priorität: 04.04.2001 DE 10116796
(71) Anmelder: SIEMENS AKTIENGESELLSCHAFT, 80333 München (DE)
(72) Erfinder: Albert, Roland, 93047, Regensburg (DE); Fritzsche, Christian, 93047, Regensburg (DE); Rekofsky, Andreas, 93087, Alteglofsheim (DE); Scheuerer, Ulf, 93047, Regensburg (DE)

(57) **Zusammenfassung**

Ein elektronisch-hydraulisches Getriebesteuermodul weist eine Hydraulikplatte (1), eine Steuerelektronik (7) und einen Sensor (4), der in einer Wand (51) einer Öffnung (5) der Hydraulikplatte unter Ausbildung einer plastischen Verformung verstemmt ist.

## Beschreibung

Die Erfindung betrifft ein elektronisch-hydraulisches Getriebesteuermodul mit einer auf einer Hydraulikplatte angeordneten Steuerelektronik und wenigstens einem Sensor, insbesondere für ein Kraftfahrzeug und ein Verfahren zur Herstellung eines solchen Getriebesteuermoduls.

Bei bekannten Getriebesteuermodulen, wie sie in Automatikgetrieben oder in automatisierten Handschaltgetrieben eingesetzt werden, müssen Sensoren zur Messung von Drücken in einem Hydraulikkanal einer Hydraulikplatte regelmäßig zweifach abgedichtet werden, um ein Austreten von Hydraulikflüssigkeit zu verhindern. Häufig ist dieser Drucksensor in einer metallischen Grundplatte des Gehäuses einer Steuerelektronik integriert. Diese Grundplatte wird dann auf eine Hydraulikplatte montiert, wobei der Drucksensor in einen Hydraulikkanal der Hydraulikplatte ragt. Es wird somit ein erster O-Ring zwischen dem Drucksensor und der Öffnung in der Grundplatte und ein zweiter O-Ring zwischen der Grundplatte und der Hydraulikplatte benötigt.

Aus der Offenlegungsschrift DE 198 34 212 A1 ist ein Getriebesteuergerät bekannt, deren Grundplatte eine Bohrung aufweist, in der ein Drucksensor druckdicht und kraftschlüssig gehalten wird. Die Grundplatte ist wiederum mit einer Dichtung gegenüber einer Hydraulikeinheit abgedichtet. Um die druckdichte Befestigung zu erreichen muss die Grundplatte wenigstens im Bereich des Sensors relativ dick ausgestaltet werden.

Das Gebrauchsmuster DE 295 13 950 U1 betrifft ein Getriebesteuergerät, das auf eine Grundplatte verzichtet. Ein Schaltungsträger, der auf seiner Oberseite die Steuerelektronik und an seiner Unterseite einen Druck-Sensor-Chip trägt, ist unmittelbar auf einer Hydraulikeinheit angeordnet. Ein Kanal in der Hydraulikeinheit, in dem sich Hydrauliköl befindet, ist direkt auf den Drucksensor hin geführt und von diesem abgedeckt. Da das Hydrauliköl unter Druck steht, werden unmittelbar Kräfte auf den Schaltungsträger übertragen, bei dem es sich üblicherweise um ein Keramiksubstrat handelt. Ferner ist die Abdichtung des Kanals gegenüber der Umgebung schwierig.

Es ist das Ziel der Erfindung, ein elektronisch-hydraulisches Getriebesteuermodul und ein Herstellungsverfahren für ein solches Getriebesteuermodul bereitzustellen, die eine einfache und öldichte Integration eines Sensors ermöglicht, der Zustände der Hydraulikflüssigkeit umfasst.

Dieses Ziel wird mit einem elektronisch-hydraulischen Getriebesteuermodul und einem Herstellungsverfahren erreicht, wie sie in den unabhängigen Patentansprüchen definiert sind. Vorteilhafte Ausführungsformen sind Gegenstand der Unteransprüche.

Da der Sensor unmittelbar in die Hydraulikplatte eingesetzt ist, kann auf eine Dichtung zwischen einer Grundplatte eines Elektronikmoduls und der Hydraulikplatte verzichtet werden. Durch ein Verstemmen oder Einpressen des Sensors in die Hydraulikplatte kann ferner eine Dichtung zwischen der Wand der Öffnung in der Hydraulikplatte und dem Sensor eingespart werden. Es sind also weder Dichtelemente noch Teile zur Befestigung des Sensors notwendig.

Soll sich beim Verstemmen des Sensors das Material der Hydraulikplatte verformen, so eignet sich als Werkstoff für den Körper bzw. das Gehäuse des Sensors insbesondere Stahl und als Material für die Hydraulikplatte Aluminium, Polyamid (PA66) oder Polybutylenterephtalat (PBT). Soll sich dagegen der Körper des Sensors verformen, so muss dessen Werkstoff leichter verformbar sein als derjenige der Hydraulikplatte.

Bei dem Sensor handelt es sich vorzugsweise um einen Drucksensor, einen Drehzahlsensor oder einen Temperatursensor, der Messungen innerhalb eines automatischen Kraftfahrzeuggetriebes oder innerhalb eines automatisierten Handschaltgetriebes vornimmt.

Weitere Vorteile, Merkmale und Anwendungsmöglichkeiten der Erfindung ergeben sich aus der nachfolgenden Beschreibung eines Ausführungsbeispiels in Verbindung mit den Zeichnungen.
Es zeigen:
- Figur 1: eine perspektivische Ansicht eines elektronischhydraulischen Getriebesteuermoduls und
- Figur 2: eine schematische Schnittdarstellung eines elektronisch-hydraulischen Getriebesteuermoduls.

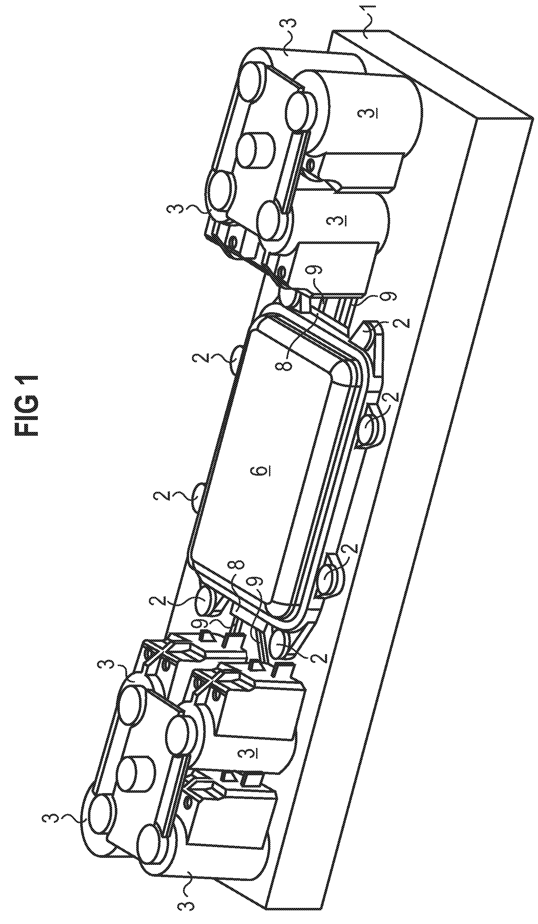

In Figur 1 ist ein elektronisch-hydraulisches Getriebesteuermodul eines Automatikgetriebes eines Kraftfahrzeugs dargestellt, das sich innerhalb dessen Ölwanne befindet. Das Getriebesteuermodul besteht aus einer Hydraulikplatte 1 oder Hydraulikeinheit mit wenigstens einem Kanal für Flüssigkeit zur Druckübertragung, aus zwei Ventilbaugruppen mit jeweils vier Magnetventilen 3 und aus einer von einem Deckel 6 geschützten Steuerelektronik.

Die Magnetventile 3 sind jeweils in Bohrungen der Hydraulikplatte 1 eingesetzt, die in Verbindung mit dem (Druckmittel-) Kanal bzw. den Kanälen stehen. Die Hydraulikplatte 1 bildet eine Gehäusewand, die die Steuerelektronik vor Umwelteinflüssen schützt.

Der haubenartige oder wannenförmige Deckel 6 des die Steuerelektronik schützenden Gehäuses ist mittels Befestigungselementen 2, beispielsweise Schrauben oder Nieten, unmittelbar an der Hydraulikplatte 1 befestigt. Eine flexible Leiterplatte 8 ist auf die Hydraulikplatte 1 laminiert und verbindet die außerhalb des Gehäusedeckels 6 angeordneten Magnetventile 3 mit der innerhalb des Deckels angeordneten Steuerelektronik. Die Steuerelektronik ist mittels einer zwischen dem Deckel 6 und der Hydraulikplatte 1 verlaufenden Dichtung nach außen gegenüber dem Getriebeöl abgedichtet. Die elektrische Verbindung zwischen Leitern der Leiterplatte 8 und den Magnetventilen 3 wird über metallische Leiter 9 hergestellt, die in die aus Kunststoff bestehende Hydraulikplatte 1 integriert sind.

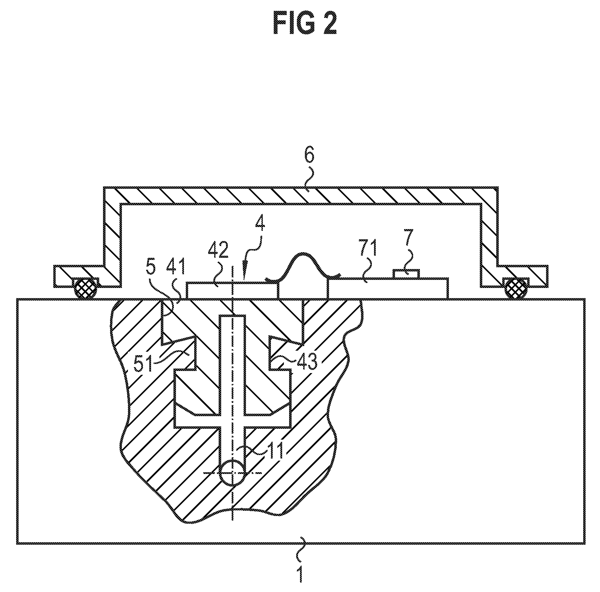

Figur 2 zeigt die auf einem Schaltungsträger 71, nämlich einen Keramiksubstrat, angeordnete Steuerelektronik 7. Diese ist genauso wie ein Sensor 4 innerhalb eines haubenartigen, wannenförmigen Deckel 6 gegenüber der Umwelt abgedichtet. Der Deckel schließt also einen Elektronikinnenraum hermetisch ab. Der Schaltungsträger 71 ist mit der Steuerelektronik 7 unmittelbar auf die Oberfläche der Hydraulikplatte geklebt.

Der Sensor 4 besteht aus einem Körper 41 oder Träger aus Stahl, der im Wesentlichen bündig mit der Oberfläche der Hydraulikplatte 1 abschließt und in einer Bohrung oder Öffnung 5 der Hydraulikplatte eingebracht ist. Auf dem Sensorkörper 41 ist ein Halbleiterchip 42 angeordnet, der Drücke misst, die in einem Kanal 11 für Hydraulikflüssigkeit herrschen, und elektrische Signale ausgibt. Der Halbleiterchip 42 des Sensors 4 ist über eine Bondverbindung mit der Steuerelektronik 7 bzw. dem Schaltungsträger 71 elektrisch kontaktiert. Der Sensor 4 liefert Messwerte an die Steuerschaltung 7, die letzterer erlauben, den Druck des Druckmittels bzw. der Hydraulikflüssigkeit im Kanal 11 zu steuern oder zu regeln.

Der Sensorkörper 41 weist eine diesen vollständig umlaufende Vertiefung 43 bzw. eine ringförmige Nut gegenüber dem restlichen Sensorkörper oder einem umlaufenden Vorsprung auf. Die Vertiefung 43 bildet eine Hinterschneidung aus. Während des Verstemmens oder Einpressens des Sensors 4 in die Öffnung 5 der Hydraulikplatte 1 wird eine plastische Verformung des Materials der Hydraulikplatte 1 erzeugt, da der Durchmesser des Sensorkörpers 41 entlang wenigstens eines Abschnitt einen größeren Durchmesser aufweist als die Öffnung 5. Material der Hydraulikplatte fließt dabei in die Vertiefung und bildet an der Hinterschneidung bzw. in der Vertiefung 43 einen Formschluss mit dem Sensorkörper 41. Es entsteht daher eine Verzahnung zwischen einer Wand 51 der Öffnung 5 und dem Sensorkörper. Ferner wird das Material der Hydraulikplatte 1 an wenigstens einem umlaufenden Abschnitt des Sensorkörpers gepresst, der in der Richtung orientiert ist, in der der Sensorkörper 41 in die Öffnung 5 eingeführt wird. Daher wird zwischen dem Sensorkörper 41 und der Wand 51 der Öffnung 5 sowohl ein Formschluss als auch ein Kraftschluss hergestellt. Dadurch wird der Sensor 4 gegenüber der Wand 51 abgedichtet, so dass ein Eindringen von Öl in den Elektronikinnenraum zuverlässig verhindert wird.

Alternativ kann auch der Körper 41 des Sensors verformt werden.

## Patentansprüche

1. Elektronisch-hydraulisches Getriebesteuermodul, das aufweist:
- eine Hydraulikplatte (1), die wenigstens einen Kanal (11) für Hydraulikflüssigkeit aufweist,
- eine auf der Hydraulikplatte (1) angeordnete Steuerelektronik (7),
- wenigstens ein Magnetventil (3), zum Steuern der Hydraulikflüssigkeit, das elektrisch mit der Steuerelektronik (7) verbunden ist,
- wenigstens einen Sensor (4), der in einer Wand (51) einer Öffnung (5) der Hydraulikplatte (1) unter Ausbildung einer plastischen Verformung verstemmt ist, und der elektrisch mit der Steuerelektronik (7) verbunden ist.

2. Getriebesteuermodul nach Anspruch 1, **dadurch gekennzeichnet, dass** der Körper (41) des Sensors wenigstens eine umlaufende Vertiefung (43) aufweist, in der verformter Werkstoff (52) der Wand (51) sowohl einen Kraftschluss als auch einen Formschluss zum Körper (41) herstellt.

3. Getriebesteuermodul nach einem der vorhergehenden Ansprüche, **dadurch gekennzeichnet, dass** die Steuerelektronik (7) einen Schaltungsträger (71) aufweist, der unmittelbar auf der Hydraulikplatte (1) angebracht ist.

4. Getriebesteuermodul nach einem der vorhergehenden Ansprüche, **dadurch gekennzeichnet, dass** ein gegenüber der Hydraulikplatte (1) abgedichteter Deckel (6) sowohl die Steuerelektronik (7) als auch den Sensor (4) einschließt.

5. Getriebesteuermodul nach dem vorhergehenden Anspruch, **dadurch gekennzeichnet, dass** wenigstens ein Magnetventil (3) an der Hydraulikplatte (1) befestigt ist, und dass das Magnetventil (3) außerhalb des Deckels (6) und von diesem beabstandet angeordnet ist.

6. Getriebesteuermodul nach einem der vorhergehenden Ansprüche, **dadurch gekennzeichnet, dass** der Körper (41) des Sensors (4) aus einer Stahllegierung besteht und die Hydraulikplatte aus einem der Materialien Aluminium, Polyamid oder Polybuthylen-Therephtalat besteht.

7. Verfahren zum Herstellen eines elektronisch-hydraulischen Getriebesteuermoduls mit den Schritten:
- ein Sensor (4), der einen größeren Durchmesser als eine Öffnung (5) in einer Hydraulikplatte (1) aufweist, wird in dieser Öffnung (5) verstemmt,
- eine Steuerelektronik (7) wird auf der Hydraulikplatte (1) befestigt,
- eine elektrische Verbindung zwischen dem Sensor (4) und der Steuerelektronik (7) wird hergestellt.
